# EUROPÄISCHE PATENTSCHRIFT

(11) **EP 0 658 810 B1**
(45) Veröffentlichungstag und Bekanntmachung des Hinweises auf die Patenterteilung: **25.11.1998**
(21) Anmeldenummer: 94116702.5
(22) Anmeldetag: 22.10.1994
(51) Int. Cl.: G03F 7/20

(54) **Beleuchtungseinrichtung für ein optisches System mit einem Reticle-Maskierungssystem**
Illumination device for an optical system with a reticle masking system
Dispositif d'illumination pour un système optique avec un système de masquage du réticule

(30) Priorität: 17.06.1994 DE 9409744 U; 13.12.1993 DE 4342424
(43) Veröffentlichungstag der Anmeldung: 21.06.1995
(73) Patentinhaber: Carl Zeiss, D-89518 Heidenheim (Brenz) (DE)
(72) Erfinder: Wangler, Johannes, D-89551 Königsbronn (DE)

(56) Entgegenhaltungen:
- EP-A- 0 297 161
- WO-A-84/01039
- 4TH (3RD INTERNATIONAL) MICROPROCESS CONFERENCE (MPC 91), KANAZAWA, JAPAN, 15-18 JULY 1991, Bd. 30,Nr. 11B, ISSN 0021-4922, JAPANESE JOURNAL OF APPLIED PHYSICS, PART 1 (REGULAR PAPERS & SHORT NOTES), NOV. 1991, JAPAN, Seiten 3021-3029, KAMON K ET AL 'Photolithography system using annular illumination'

## Beschreibung

Anmeldegegenstand ist eine Beleuchtungseinrichtung für ein optisches System, insbesondere eine mikrolithographische Projektions-Belichtungsanlage mit einem Reticle-Maskierungssystem.

Mit einer Projektions-Belichtungsanlage können unterschiedliche Mikrochips hergestellt werden, wobei sich die Formate der Masken auf dem Reticle unterscheiden können. Es ist daher notwendig, eine variable exakte Begrenzung des Beleuchtungsflecks auf dem Reticle vorzusehen, da sonst Belichtungsfehler auftreten. Anordnungen möglichst nahe am Reticle behindern dessen Handhabung und können die Anforderungen an die Kantensteilheit der Blendenwirkung, wie sie für hoch aufgelöste Strukturen gestellt sind, nicht erfüllen. Bekannt ist es daher, z.B. aus WO 84/01039 im Beleuchtungsstrahlengang eine zusätzliche Zwischen-Feldebene zu schaffen, in der das Reticle-Masking-System exakt positioniert werden kann. Die dafür nötigen zusätzlichen Linsen erfordern bei den gegebenen Forderungen hinsichtlich Bildfeld, Apertur, Homogenität und Achromasie einen hohen Aufwand und zusätzlichen Bauraum.

EP 0 297 161 A1 gibt für eine Projektions-Belichtungsanlage mit Lichtleiter-Glasstab im Beleuchtungs-Strahlengang an, daß nach dem Glasstab ein Verlaufsfilter angebracht werden kann. Dies dient offenbar der weiteren Homogenisierung, nicht der Abblendung.

Aufgabe ist es daher, ein Reticle-Maskierungs-System mit hoher Güte und geringem Mehraufwand zu schaffen.

Dies gelingt für eine gattungsgemäße Beleuchtungsanordnung mit den kennzeichnenden Merkmalen des Anspruchs 1, wonach ein Glasstab zur Lichthomogenisierung vorgesehen ist und das Reticle-Maskierungs-System am Austrittsende des Glasstabs angeordnet ist. Bei gattungsgemäßen Beleuchtungsanordnungen sind Wabenkondensoren zur Homogenisierung der Lichtverteilung üblich. Alternativ kann ein Glasstab diese Funktion übernehmen. Es wird nun davon Gebrauch gemacht, daß an dessen Austrittsende eine für die Reticle-Maskierung geeignete Zwischen-Feldebene vorhanden ist. Zusätzliche Maßnahmen zur Erzeugung einer Zwischen-Feldebene sind also nicht erforderlich.

Vorteilhafte Ausführungsformen sind Gegenstand der Unteransprüche. Die Gegenstände der Ansprüche 2, 3 und 13 bis 19 sind auch in der Patentanmeldung "Beleuchtungseinrichtung" DE 44 21 053.1 vom gleichen Anmeldetag, Anmelder und Erfinder beschrieben.

Die Gegenstände der Ansprüche 4 bis 12 sind auch in der Patentanmeldung DE 43 42 424 vom 13.12.1993, deren Priorität beansprucht wird, beschrieben.

Zur näheren Beschreibung dient die Zeichnung.
- Fig. 1: zeigt schematisch eine Ausführungsform mit Zoom-Axicon;
- Fig. 2a: zeigt schematisch eine Ausführungsform mit verstellbarer Spiegelanordnung zur Wahl der Beleuchtungsart in seitlicher Darstellung;
- Fig. 2b: zeigt das gleiche in Aufsicht.

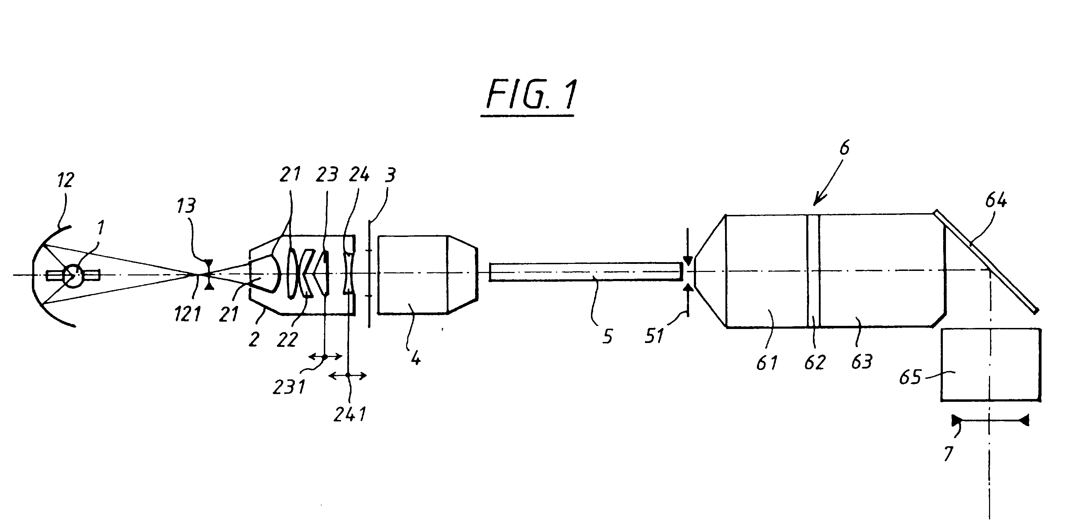

Fig. 1 ist auch in oben genannter gleichzeitiger Patentanmeldung enthalten und beschrieben.

Figur 1 zeigt ein Beispiel einer erfindungsgemäßen Beleuchtungseinrichtung für die Projektions-Lithographie bei Auflösungen bis unterhalb 1 µm, z.B. für die Herstellung integrierter Schaltkreise.

Eine Lampe (1), eine Quecksilber-Kurzbogenlampe für die i-Linie von 365 nm Wellenlänge, ist im einen Brennpunkt eines elliptischen Spiegels (12) angeordnet, der das emittierte Licht im zweiten Brennpunkt (121) sammelt.

Abweichend von der Regel ist der Verschluß (13) außerhalb des Brennpunktes (121) angeordnet, und zwar ist der Abstand zum Scheitel des elliptischen Spiegels (12) etwa 5% bis 20%, vorzugsweise 10%, größer als der Abstand des Brennpunkts (121) zum Scheitel. Dadurch wird erreicht, daß die hier gebildete sekundäre Lichtquelle homogener wird und die partiell kohärente Wirkung der Beleuchtung auf die optische Abbildung verbessert wird. Ein extra Misch-System zu diesem Zweck kann damit eingespart werden. Diese Maßnahme ist auch bei einer sonst konventionellen Beleuchtungseinrichtung sinnvoll.

Alternativ ist auch ein UV-Laser als Lichtquelle sinnvoll.

Das folgende Objektiv (2) besteht aus einer ersten Linsengruppe (21), dem konkaven ersten Axicon (22), dem konvexen zweiten Axicon (23) und einer zweiten Linsengruppe (24). Stellmittel (231) und (241) erlauben die axiale Verschiebung eines Axicons (23) und eines Elements der zweiten Linsengruppe (24). Damit kann sowohl der Abstand der Axicons (22, 23) untereinander verstellt werden und somit der Ringaperturcharakter verändert werden, als auch eine Zoom-Wirkung zur Veränderung des ausgeleuchteten Pupillendurchmessers, also des Kohärenzgrads (σ), erreicht werden.

Nach der Pupillenzwischenebene (3) folgt ein zweites Objektiv (4), mit dem das Licht in den Glasstab (5) von ca. 0,5 m Länge eingekoppelt wird. Der Ausgang des Glasstabs (5) ist eine Zwischen-Feldebene, in der ein Maskierungssystem (51) angeordnet ist, das anstelle konventioneller REMA- (reticle masking) Systeme eingesetzt wird. Die sonst übliche Schaffung einer zusätzlichen Zwischen-Feldebene für das REMA-System mit aufwendigen Linsengruppen wird eingespart.

Die Ausbildung des Reticle-Maskierungs-Systems (51) entspricht ansonsten den üblichen feinmechanischen Ausführungen. Es ist jedoch darauf zu achten, daß die Begrenzungslinien exakt in einer Ebene verlaufen. Vorteilhaft ist eine Ausbildung mit symmetrisch zur optischen Achse schräg stehenden Blendenschneiden, da so Reflexe von deren Flächen wirksam aus dem Strahlengang der Beleuchtungseinrichtung entfernt werden können.

Das folgende Objektiv (6) bildet die Zwischen-Feldebene mit dem Maskierungssystem (51) auf das Reticle (7) (Maske, Lithographievorlage) ab und enthält eine erste Linsengruppe (61), eine Pupillen-Zwischenebene (62), in die Filter oder Blenden eingebracht werden können, zweite und dritte Linsengruppen (63 und 65) und dazwischen einen Umlenkspiegel (64), der es ermöglicht, die große Beleuchtungseinrichtung (ca. 3 m Länge) horizontal einzubauen und dabei das Reticle (7) waagerecht zu lagern.

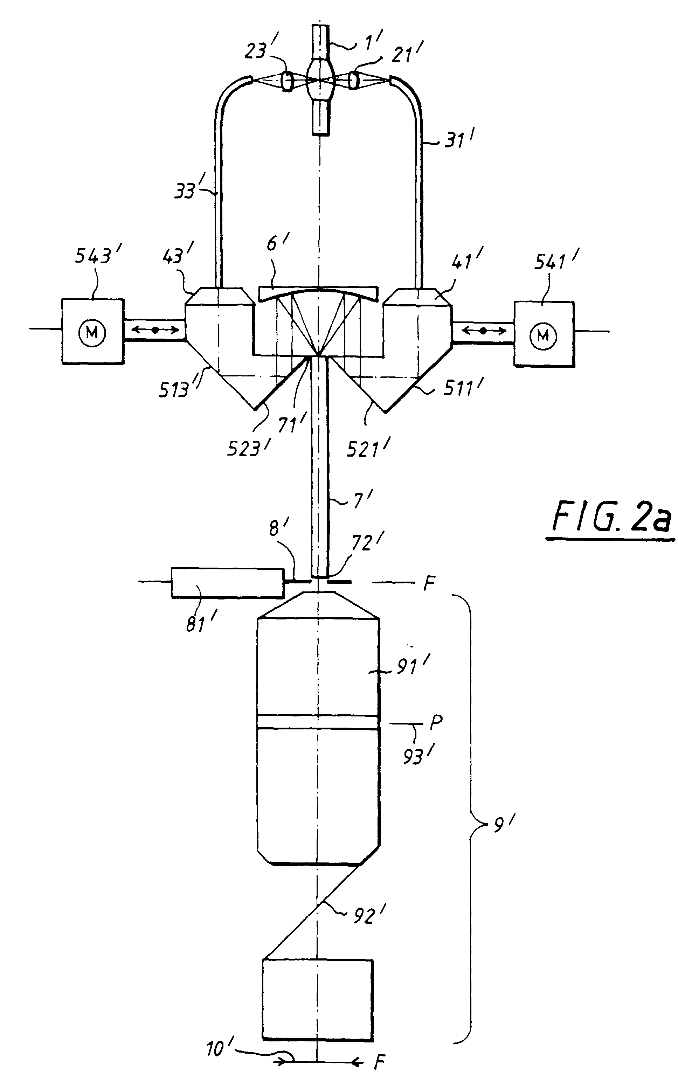

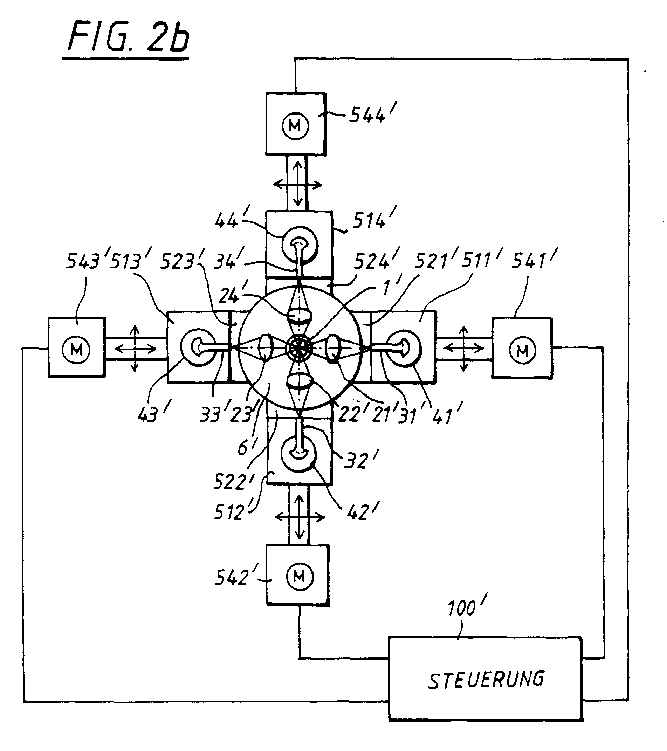

In Figur 2a und in Figur 2b ist eine Quecksilber-Kurzbogenlampe als Lichtquelle (1') dargestellt, von deren Lichtfluß vier Kollektoren (21' -24') jeweils einen großen Raumwinkelbereich erfassen, so daß ein Großteil des Lichts den vier Lichtleitern (31' -34') zugeführt wird. Die Lichtleiter (31' -34') sind als Querschnittswandler ausgebildet, deren Austrittsflächen ringsegmentförmig sind. Zur weitgehenden Homogenisierung der Lichtintensität über die Austrittsflächen sind die Lichtleiter (31' -34') z.B. aus statistisch durchmischten Einzelfasern zusammengesetzt. Auch kann ihr Eingangsquerschnitt an die Lichtverteilung angepaßt sein.

Alternativ kann die Beleuchtung der Lichtleiter (31' -34') auch durch einen Laser mit Strahlaufweitungsoptik und Pyramidenspiegel als geometrischem Strahlteiler realisiert werden. Der Laser ist dann z.B. ein im UV emittierender Excimer-Laser.

An die Austrittsflächen der vier Lichtleiter (31' -34') schließen sich je eine Einheit aus einer Relaisoptik (41'-44'), einem ersten Umlenkspiegel (511' -514') und einem zweiten Umlenkspiegel (521' -524') an. Diese Einheiten einschließlich der verbundenen Enden der flexibel ausgeführten Lichtleiter (31' -34') sind durch Stellantriebe (541' -544') jeweils radial und azimutal verstellbar bzw. scanbar. Eine Steuerung (100') kontrolliert die Stellantriebe (541' -544').

Über den Einkoppelspiegel (6') wird das von den vier Umlenkspiegeln (521' -524') kommende Licht auf die Eintrittsfläche (71') eines Glasstabs (7') abgebildet. Diese Eintrittsfläche (71') liegt in einer Pupillenebene P der Beleuchtungsanordnung und jede der vier Einheiten kann je nach Stellung der Stellantriebe (541' -544') jeweils Teile eines Quadranten dieser Eintrittsfläche ausleuchten. Die vier von den Kollektoren (21' -24') erfaßten Lichtströme werden also hier geometrisch zusammengesetzt zu einer effektiven sekundären Lichtquelle.

Bei der Austrittsfläche (72') des Glasstabes (7') befindet sich eine Feldebene F, in der erfindungsgemäß ein Reticle-Masking-System (8'), also eine verstellbare Blende, angeordnet ist. Mit dem Stellmittel (81') wird das Reticle-Masking-System (REMA) bedarfsgemäß verstellt.

Das Reticle-Masking-System (8') an dieser Stelle erspart gegenüber bekannten Lösungen den Aufwand für die Bereitstellung einer zusätzlichen Feldebene nur für das Reticle-Masking-System.

Das folgende Zwischenabbildungssystem (9') ist ein Objektiv mit einer Pupillenebene P (93'), davor dem Inter-Masking-System (91') und danach einer symbolisch dargestellten Strahlumlenkung (93'), bestehend aus einem Planspiegel, welcher in bekannter Weise einen kompakteren Gesamtaufbau ermöglicht. Es folgt das zu beleuchtende Reticle (10) in der Feldebene F.

In der Anmeldung DE-P 43 42 424 sind diese Figuren 2a und 2b enthalten und beschrieben.

Das folgende Projektionsobjektiv und der zu belichtende Wafer sind bekannt und nicht dargestellt.

## Patentansprüche

1. Beleuchtungseinrichtung für ein optisches System, insbesondere eine mikrolithographische Projektionsbelichtungsanlage, mit einem Reticle-Maskierungs-System (51), dadurch gekennzeichnet, daß ein Glasstab (5) zur Lichthomogenisierung vorgesehen ist und das Reticle-Maskierungs-System (51) an einer Zwischen-Feldebene am Austrittsende des Glasstabs (5) angeordnet ist.

2. Beleuchtungseinrichtung nach Anspruch 1, dadurch gekennzeichnet, daß zwischen Lichtquelle (1) und Glasstab (5) ein Objektiv (2) mit Axicon (24) angeordnet ist.

3. Beleuchtungseinrichtung nach Anspruch 2 mit zwei Axicons (22, 23), dadurch gekennzeichnet, daß durch Verstellen des Abstands der beiden Axicons (21, 23) stufenlos sowohl konventionelle Beleuchtung als auch Ringapertur- oder Multipolbeleuchtung verschiedener Geometrie eingestellt werden können.

4. Beleuchtungseinrichtung nach Anspruch 1, dadurch gekennzeichnet, daß zwischen Lichtquelle (1') und Glasstab (7') eine Anordnung vorgesehen ist für die wahlweise Bereitstellung verschiedener Beleuchtungsarten einschließlich konventioneller Beleuchtung mit einstellbarem Kohärenzfaktor (σ), Ringaperturbeleuchtung und symmetrischer schiefer Beleuchtung aus zwei oder vier Richtungen
- mit Mitteln (21'-24') zum getrennten Erfassen von Lichtflüssen aus zwei oder vier Raumwinkelbereichen des von der Lichtquelle (1') emittierten Lichtflusses,
- mit Mitteln (31'-34') zum Formen oder Ausblenden der erfaßten Lichtflüsse,
- mit einer Spiegelanordnung (511'-514', 521'-524', 531', 533'; 6') zur Abbildung der Lichtflüsse auf Sektoren einer Pupillenebene (93'), die konjugiert zur Reticleebene für das abzubildende Reticle (10') ist,
- mit Verstellmitteln (541'-544') derart, daß die Bilder der Lichtflüsse in der Pupillenebene (93') radial und azimutal verschoben werden können.

5. Beleuchtungseinrichtung nach Anspruch 4, dadurch gekennzeichnet, daß die Mittel zum Erfassen (21' -24') oder die Mittel zum Formen (31' -34') oder Ausblenden der erfaßten Lichtflüsse Lichtleiter (31'-34') enthalten.

6. Beleuchtungseinrichtung nach Anspruch 5, dadurch gekennzeichnet, daß die Verstellmittel (541'-544') die Lage der Ausgänge der Lichtleiter (31' -34') verstellen.

7. Beleuchtungseinrichtung nach Anspruch 4, dadurch gekennzeichnet, daß die Verstellmittel (541' -544') Teile der Spiegelanordnung (511'-533') verstellen.

8. Beleuchtungseinrichtung nach mindestens einem der Ansprüche 4-7, dadurch gekennzeichnet, daß die Bilder der Lichtflüsse in der Pupillenebene (93') so dimensioniert sind, daß sie ohne Scanningbewegung geeignet sind für die symmetrische schiefe Beleuchtung oder für die konventionelle Beleuchtung.

9. Beleuchtungseinrichtung nach mindestens einem der Ansprüche 4-8, dadurch gekennzeichnet, daß Mittel zum Verändern der Größe der Bilder der Lichtflüsse in der Pupillenebene vorgesehen sind.

10. Beleuchtungseinrichtung nach mindestens einem der Ansprüche 4-9, dadurch gekennzeichnet, daß Mittel zum Verändern der Form der Lichtflüsse vorgesehen sind.

11. Beleuchtungseinrichtung nach mindestens einem der Ansprüche 4-10, dadurch gekennzeichnet, daß die Lichtflüsse in Ringsegmentform gebracht werden.

12. Beleuchtungseinrichtung nach mindestens einem der Ansprüche 1-12, dadurch gekennzeichnet, daß die Lichtquelle ein Laser ist.

13. Beleuchtungseinrichtung für ein optisches System, insbesondere eine mikrolithographische Projektionsbelichtungsanlage nach Anspruch 1, 2 oder 3, mit zwei Axicons (22, 23), dadurch gekennzeichnet, daß die zwei Axicons (22, 23) im Strahlengang unmittelbar aufeinander folgen und ihr Abstand verstellbar ist, ein Axicon (22) konkav und ein zweites Axicon (23) konvex ist und die Spitzen der beiden Axicons (22, 23) in die gleiche Richtung weisen.

14. Beleuchtungseinrichtung nach Anspruch 13, dadurch gekennzeichnet, daß die Axicons (22, 23) soweit fertigungstechnisch machbar und funktionell wirksam gleichen Spitzenwinkel (α) haben.

15. Beleuchtungseinrichtung nach Anspruch 13 oder 14, dadurch gekennzeichnet, daß der Abstand (d23) der beiden Axicons (22, 23) bis zur Berührung reduziert werden kann.

16. Beleuchtungseinrichtung nach mindestens einem der Ansprüche 13-15, dadurch gekennzeichnet, daß die Axicons (22, 23) konisch sind.

17. Beleuchtungseinrichtung nach mindestens einem der Ansprüche 13-15, dadurch gekennzeichnet, daß die Axicons (22, 23) pyramidenförmig sind.

18. Beleuchtungseinrichtung nach mindestens einem der Ansprüche 1-17, dadurch gekennzeichnet, daß sie ein Objektiv (2) mit Zoomfunktion enthält.

19. Beleuchtungseinrichtung nach mindestens einem der Ansprüche 1-18 mit einer Lichtquelle (1) in einem Fokus eines Lampenspiegels, dadurch gekennzeichnet, daß eine eine sekundäre Lichtquelle bildende Blende (13) außerhalb eines Fokus (121) des Lampenspiegels (12) angeordnet ist.

20. Beleuchtungsanordnung nach mindestens einem der Ansprüche 1-19, dadurch gekennzeichnet, daß das Reticle-Maskierungssystem (51) schräg gestellte Blendenbleche aufweist.

## Claims

1. Illumination arrangement for an optical system, preferably a microlithographic projection exposure system, with a reticle masking system (51),
characterized in that
a glass rod (5) is provided for homogenization of light and that the reticle masking system (51) is arranged at an intermediate field plane at the exit end of the glass rod (5).

2. Illumination arrangement according to claim 1, characterized in that an objective (2) with an axicon (24) is arranged between light source (1) and glass rod (5).

3. Illumination arrangement according to claim 2 with two axicons, characterized in that conventional illumination as well as annular aperture- and multipole-illumination can be adjusted in a stepless manner.

4. Illumination arrangement according to claim 1, characterized in that an arrangement is provided between light source (1') and glass rod (7') for alternatively providing different illumination modi, including conventional illumination with adjustable factor of coherence (σ), annular aperture illumination and symmetrical off-axis illumination from two or four directions, comprising
- means (21'-24') for separately receiving light fluxes from two or four spatial angle zones of the light flux emitted by the light source (1')
- means (31'-34') for forming or stopping down the received light fluxes,
- a mirror arrangement (511'-514', 521'-524', 531'-533'; 6') for imaging the light fluxes onto sectors of a pupil plane (93'), which is conjugated to the reticle plane for the reticle (10') to be imaged,
- displacing means (541'-544') such that the images of the light fluxes can be shifted radially and azimuthally in the pupil plane (93').

5. Illumination arrangement according to claim 4, characterized in that the means for receiving (21'-24') or the means for forming (31'-34') or stopping down the received light fluxes comprise light conductors (31'-34').

6. Illumination arrangement according to claim 5, characterized in that the displacing means (541'-544') displace the positions of the exits of the light conductors (31'-34').

7. Illumination arrangement according to claim 4, characterized in that the displacing means (541'-544') displace parts of the mirror arrangement (511'-533').

8. Illumination arrangement according to at least one of claims 4-7, characterized in that the images of the light fluxes in the pupil plane (93') are dimensioned such that they are suitable for the symmetrical oblique illumination or for the conventional illumination without of a scanning movement.

9. Illumination arrangement according to at least one of the claims 4-8, characterized in that means for changing the magnitude of the images of the light fluxes are provided.

10. Illumination arrangement according to at least one of the claims 4-9, characterized in that means for changing the shape of the light fluxes are provided.

11. Illumination arrangement according to at least one of the claims 4-10, characterized in that the light fluxes are changed to a ring segment shape.

12. Illumination arrangement according to at least one of the claims 1-11, characterized in that the light source is a laser.

13. Illumination arrangement for an optical system, preferably a microlithographic projection exposure system according to claims 1, 2 or 3 with two axicons, characterized in that the two axicons follow each other directly in the beam path and that their distance is adjustable, that one axicon is concave and a second axicon is convex and that the tips of both axicons direct in the same direction.

14. Illumination arrangement according to claim 13, characterized in that the axicons (22, 23) have the same top angle (a) as far as feasible in production and effective in function.

15. Illumination arrangement according to claim 13 or 14, characterized in that the distance (d23) of the two axicons can be reduced to touch.

16. Illumination arrangement according to at least one of the claims 13-15, characterized in that the axicons (22, 23) are conical.

17. Illumination arrangement according to at least one of the claims 13-15, characterized in that the axicons (22, 23) are pyramid shaped.

18. Illumination arrangement according to at least one of the claims 1-17, characterized in that it contains an objective with zoom function.

19. Illumination arrangement according to at least one of the claims 1-18 with a light source (1) in a focus of a lamp mirror, characterized in that a stop (13) which defines a secondary light source is arranged out of focus (121) of the lamp mirror (12).

20. Illumination arrangement according to at least one of the claims 1-19, characterized in that the reticle masking system (51) has diaphragm plates arranged in an inclined manner.

## Revendications

1. Dispositif d'éclairage destiné à un système optique, notamment une installation d'exposition pour la microlithographie par projection, doté d'un système de masquage du réticule (51), caractérisé en ce qu'une tige en verre (5) est prévue pour homogénéiser la lumière et que le système de masquage du réticule (51) est disposé dans un plan de champ intermédiaire à la sortie de la tige en verre (5).

2. Dispositif d'éclairage selon la revendication 1, caractérisé en ce qu'un objectif (2) avec un Axicon (24) est disposé entre la source de lumière (1) et la tige en verre (5).

3. Dispositif d'éclairage selon la revendication 2 comprenant deux Axicons (22, 23), caractérisé en ce que l'on peut régler progressivement un éclairage classique, un éclairage d'ouverture annulaire et un éclairage multipolaire de différentes géométries, en modifiant l'écart séparant les deux Axicons (22, 23).

4. Dispositif d'éclairage selon la revendication 1, caractérisé en ce qu'un ensemble prévu entre la source de lumière (1') et la tige en verre (7') permet de recourir au choix à différents types d'éclairage, y compris l'éclairage classique avec un facteur de cohérence (σ) réglable, un éclairage d'ouverture annulaire et un éclairage oblique symétrique dans deux ou quatre directions, ensemble qui comprend
- des moyens (21'-24') pour capter séparément la lumière émise par la source de lumière (1') dans deux ou quatre secteurs angulaires,
- des moyens (31'-34') pour la mise en forme ou le diaphragmage des flux lumineux captés,
- un ensemble de miroirs (511'-514', 521'-524', 531', 533'; 6') servant à reproduire les flux lumineux sur les secteurs d'un plan de pupille (93') qui est conjugué au plan du réticule à reproduire (10'),
- des moyens de réglage (541'-544') de chaque flux lumineux permettant de déplacer librement dans les sens radial et axial les images des flux lumineux dans le plan de pupille (93').

5. Dispositif d'éclairage selon la revendication 4, caractérisé en ce que les moyens pour capter la lumière (21'-24') ou les moyens pour mettre en forme (31'-34') ou pour diaphragmer les flux lumineux captés comprennent des conducteurs de lumière (31'-34').

6. Dispositif d'éclairage selon la revendication 5, caractérisé en ce que les moyens de réglage (541'-544') positionnent les sorties des conducteurs de lumière (31'-34').

7. Dispositif d'éclairage selon la revendication 4, caractérisé en ce que les moyens de réglage (541'-544') agissent sur des éléments de l'ensemble de miroirs (511'-533').

8. Dispositif d'éclairage selon l'une quelconque des revendications 4 à 7, caractérisé en ce que les images des flux lumineux dans le plan de pupille (93') sont dimensionnées de manière à se prêter sans mouvement de balayage à l'éclairage oblique symétrique ou à l'éclairage classique.

9. Dispositif d'éclairage selon l'une quelconque des revendications 4 à 8, caractérisé en ce qu'il comprend des moyens permettant de faire varier la taille des images des flux lumineux dans le plan de pupille.

10. Dispositif d'éclairage selon l'une quelconque des revendications 4 à 9, caractérisé en ce qu'il comprend des moyens permettant de faire varier la forme des flux lumineux.

11. Dispositif d'éclairage selon l'une quelconque des revendications 4 à 10, caractérisé en ce que les flux lumineux sont mis en forme de manière à présenter un profil en segment d'anneau.

12. Dispositif d'éclairage selon l'une quelconque des revendications 1 à 12, caractérisé en ce que la source de lumière est un laser.

13. Dispositif d'éclairage destiné à un système optique, notamment une installation d'exposition pour la microlithographie par projection selon la revendication 1, 2 ou 3, doté de deux Axicons (22, 23) et caractérisé en ce que lesdits Axicons (22, 23) se succèdent immédiatement dans le trajet lumineux, que l'écart qui les sépare est réglable, qu'un Axicon (22) est concave et l'autre Axicon (23) convexe et que les pointes des deux Axicons (22, 23) sont orientées dans le même sens.

14. Dispositif d'éclairage selon la revendication 13, caractérisé en ce que les pointes des Axicons (22, 23) présentent des angles (α) égaux dans la mesure où la fonction est remplie et où les techniques de fabrication le permettent.

15. Dispositif d'éclairage selon la revendication 13 ou 14, caractérisé en ce que l'écart (d23) qui sépare les deux Axicons (22, 23) peut être réduit jusqu'à ce qu'ils se touchent.

16. Dispositif d'éclairage selon l'une quelconque des revendications 13 à 15, caractérisé en ce que les Axicons (22, 23) ont une forme conique.

17. Dispositif d'éclairage selon l'une quelconque des revendications 13 à 15, caractérisé en ce que les Axicons (22, 23) présentent une forme de pyramide.

18. Dispositif d'éclairage selon l'une quelconque des revendications 1 à 17, caractérisé en ce qu'il comprend un objectif (2) offrant une fonction de zoom.

19. Dispositif d'éclairage selon l'une quelconque des revendications 1 à 18 avec une source de lumière (1) disposée dans un foyer d'un miroir de lampe, caractérisé en ce qu'un diaphragme (13) formant source de lumière secondaire est disposé au dehors d'un foyer (121) du miroir de lampe (12).

20. Dispositif d'éclairage selon l'une quelconque des revendications 1 à 19, caractérisé en ce que le système de masquage du réticule (51) présente des lamelles de diaphragme en position inclinée.
